# EUROPÄISCHE PATENTANMELDUNG

(11) **EP 4 269 654 A1**
(43) Veröffentlichungstag der Anmeldung: **01.11.2023**
(21) Anmeldenummer: 22170434.9
(22) Anmeldetag: 28.04.2022
(51) Int. Cl.: C23C 28/04, C23C 30/00, B23D 61/12, B23D 65/00, C23C 14/32, C23C 14/06, C23C 14/50

(54) **SÄGEBLATT, HERSTELLUNGSVERFAHREN UND KASSETTE**

(71) Anmelder: Hilti Aktiengesellschaft, 9494 Schaan (LI)
(72) Erfinder: Momeni, Siavash, 8050 Zürich (CH); Moseley, Steven, 6820 Nenzing-Gurtis (AT); Icöz, Can, 80796 München (DE)
(74) Vertreter: Hilti Aktiengesellschaft Corporate Intellectual Property

(57) **Zusammenfassung**

Die Erfindung betrifft ein verschleißoptimiertes Sägeblatt (10), insbesondere ein linear schneidendes Sägeblatt (10) für eine Säbelsäge oder eine Stichsäge, umfassend einen Grundkörper (12), an dem wenigstens ein Sägezahn (14) angeordnet und / oder ausgebildet ist. Der Sägezahn (14) weist ein Substrat (18) auf, das wenigstens teilweise mit einer Beschichtung (20) beschichtet ist. Die Beschichtung (20) weist eine Haftvermittlungsschicht (20.1) und wenigstens eine keramische Schutzschicht (20.2, 20.3) auf, wobei die Schutzschicht (20.2, 20.3) verschleißfester als das Substrat (18) ist. Des Weiteren betrifft die Erfindung ein Herstellverfahren sowie eine Kassette (300) zur Aufnahme von Sägeblättern (10).

## Beschreibung

Die Erfindung betrifft ein Sägeblatt, umfassend einen Grundkörper, an dem wenigstens ein Sägezahn angeordnet und / oder ausgebildet ist.

Insbesondere beim Durchtrennen widerstandsfähiger Materialien wie beispielsweise Stählen sind Sägeblätter hohen Belastungen ausgesetzt und weisen infolgedessen einen raschen Verschleiß auf.

Aufgabe der vorliegenden Erfindung ist es daher, ein Sägeblatt mit besonders langen Standzeiten und dennoch niedrigen Herstellungskosten, ein Herstellungsverfahren zu dessen Herstellung sowie eine Komponente, die eine kostengünstige Herstellung eines solchen Sägeblatts ermöglicht, anzubieten.

Gelöst wird die Aufgabe durch **ein Sägeblatt,** umfassend einen Grundkörper, an dem wenigstens ein Sägezahn angeordnet und / oder ausgebildet ist, wobei der Sägezahn ein Substrat aufweist, das wenigstens teilweise mit einer Beschichtung beschichtet ist, wobei die Beschichtung eine Haftvermittlungsschicht und wenigstens eine keramische Schutzschicht aufweist, wobei die Schutzschicht verschleißfester als das Substrat ist.

Verschleißfestigkeit kann dabei eine hohe Abriebfestigkeit umfassen und / oder einer solchen entsprechen. Verschleißfestigkeit kann alternativ oder ergänzend auch eine hohe Härte umfassen und / oder einer solchen entsprechen. Auch kann Verschleißfestigkeit alternativ oder ergänzend eine hohe Bruchfestigkeit umfassen und / oder einer solchen entsprechen.

Weist das Substrat mehrere Materialien auf, kann die Schutzschicht verschleißfester als das verschleißfesteste der Materialien der Schutzschicht sein.

Somit kann die Schutzschicht das Substrat schützen. Schäden an dem Sägezahn, beispielsweise ein Abbrechen von Teilbereichen des Sägezahns und / oder Abrieb, können reduziert und / oder vermieden werden. Durch die Haftvermittlungsschicht kann ein Verschleiß, beispielsweise Abrieb, der Schutzschicht selbst reduziert werden. Insbesondere kann ein verfrühtes lokales Abblättern oder Abbrechen der Schutzschicht vermindert oder sogar vermieden werden, sodass das Sägeblatt eine besonders lange Lebensdauer aufweisen kann.

Das Sägeblatt kann zum Sägen von Metallen und / oder anderen Hartstoffen ausgebildet sein. Dazu kann es beispielsweise entsprechend geformte Sägezähne aufweisen. Es kann ein lineares Sägeblatt, insbesondere ein Sägeblatt für eine Säbelsäge und / oder eine Stichsäge, beispielsweise für eine Pendelhubstichsäge, sein.

Das Substrat kann ein Metall aufweisen. Es kann eine Legierung umfassen und / oder sein. Beispielsweise kann es ein Bimetall aufweisen. Alternativ oder ergänzend kann es ein Hartmetall, beispielsweise ein Wolframcarbid-Hartmetall aufweisen. Es kann auch keramisch sein und / oder eine Keramik umfassen.

Die Haftvermittlungsschicht kann dazu eingerichtet sein, Unterschiede zwischen dem Substrat und dem Material der Schutzschicht, beispielsweise hinsichtlich von Elastizitäten und / oder thermischen Ausdehnungskoeffizienten, auszugleichen. Die Haftvermittlungsschicht kann ein oder mehrere Haftvermittlungsschicht-Teilschichten aufweisen. Wenigstens zwei der Haftvermittlungsschicht-Teilschichten können sich beispielsweise in ihren Elastizitäten und / oder in ihren stofflichen Zusammensetzungen unterscheiden.

Die Schutzschicht kann mehrere Teilschichten aufweisen. Die Teilschichten können eingerichtet sein, wenigstens zwei verschiedene Funktionen zu erfüllen und / oder wenigstens eine unterschiedliche Eigenschaft aufzuweisen. Beispielsweise kann eine Teilschicht eine besonders hohe Härte aufweisen, während die andere, insbesondere eine auf einer Außenseite der Beschichtung ausgebildete Teilschicht, Oxidations-verhindernd ausgebildet sein kann.

Wenigstens zwei der Teilschichten können sich in ihren stofflichen Zusammensetzungen unterscheiden.

Die Beschichtung kann eine Dicke von mindestens 1 µm, insbesondere von wenigstens 2 µm, aufweisen. Ihre Dicke kann höchstens 6 µm, insbesondere höchstens 4µm, betragen. Erfahrungsgemäß kann mit einer Beschichtung entsprechend einem solchen Dickenbereich eine hinreichende Standfestigkeit erreicht werden. Produktionszeiten und Herstellungskosten können sich dennoch in einem akzeptablen Bereich bewegen. Bei der genannten Mindestdicke kann auch sichergestellt sein, dass selbst bei üblichen Fertigungsschwankungen der Beschichtungsdicken an allen gewünschten Stellen eine für die Gesamtfunktion der Beschichtung hinreichende Dicke erreicht werden kann. Dabei können die genannten Dickenangaben als Ist- und / oder als Soll-Angaben der zu erreichenden Beschichtungsdicke zu verstehen sein. Dies kann insbesondere gelten, wenn das Sägeblatt nach einem nachfolgend noch zu beschreibenden Verfahren hergestellt wird.

Besonders günstige Schneidleistungen haben sich ergeben, wenn die Beschichtung eine Härte von 2500 - 3000, beispielsweise gemessen nach ISO 21874:2019 "PVD multi-layer hard coatings - Composition, structure and properties", aufweist. Die Messungenauigkeit dieses Bereichs kann ± 500 HV betragen. Diese Härte kann wenigstens auf 50%, insbesondere 80%, der beschichteten Oberfläche, besonders bevorzugt auf der gesamten beschichteten Oberfläche, gegeben sein.

Denkbar ist, dass die Haftvermittlungsschicht Titan aufweist. Beispielsweise kann die Haftvermittlungsschicht eine Titan-haltige Legierung und / oder ein Titan-haltiges Kompositmaterial aufweisen.

Die Haftvermittlungsschicht kann einen Konzentrationsgradienten aufweisen. Der Konzentrationsgradient kann vom Substrat weg gerichtet, insbesondere zu einer Außenseite der Beschichtung hin, verlaufen. Entlang des Konzentrationsgradienten kann die Haftvermittlungsschicht von, zumindest überwiegend, metallischen und / oder kompositmetallischen zu, zumindest überwiegend, keramischen Eigenschaften wechseln.

Die Haftvermittlungsschicht kann Titan und / oder Titannitrid aufweisen. Sie kann auch Cr-CrN und/oder AICrN aufweisen. Sie kann beispielsweise angrenzend an das Substrat eine hohe Konzentration an Titan und / oder Titannitrid aufweisen. Diese Konzentration kann in Richtung der Schutzschicht abfallen. Im Gegenzug kann eine Konzentration von Cr-CrN und / oder AICrN in Richtung auf die Schutzschicht von einer niedrigen zu einer hohen Konzentration ansteigen.

Die Schutzschicht, insbesondere zumindest eine Teilschicht, insbesondere eine mittlere Teilschicht, kann wenigstens einen Stoff aus der Gruppe AITiCN, TiAINi, TiAIN, AITiSiCN oder TiCN aufweisen. Besonders günstige Ergebnisse lieferte eine Schutzschicht mit AITiSiCN.

Die Schutzschicht, insbesondere die Teilschicht, kann auch wenigstens einen Stoff aus der Gruppe Silizium, Zirkonium oder AICrN aufweisen.

Allgemein kann die Schutzschicht thermisch vergleichsweise stabil ausgebildet sein. Sie kann wesentlich zur Verschleißfestigkeit und damit zu einer langen Lebensdauer des Sägezahns bzw. des Sägeblatts beitragen.

Die Schutzschicht oder zumindest eine Teilschicht der Schutzschicht kann eine kristalline Struktur aufweisen. Die Struktur kann auch säulenförmig sein.

Die mittlere Teilschicht kann als mono- oder multilayer-Schicht ausgebildet sein. Eine äußerste Teilschicht kann bevorzugt als monolayer-Schicht ausgebildet sein.

Der Grundkörper kann einen Stahl aufweisen. Der Stahl kann einen hohen Kohlenstoffanteil aufweisen. Beispielsweise kann es sich um 50CrV4- oder 51CrV4-Stahl handeln.

Der Sägezahn kann wenigstens ein Hartmetallstück aufweisen. Das Hartmetallstück kann ein Wolframkarbid und / oder ein Wolframborid, beispielsweise WB₂, WB₃, WB₄ und / oder WB₅, aufweisen. Das Hartmetallstück kann ein Bindermaterial aufweisen. Das Bindermaterial kann beispielsweise Kobalt und / oder Nickel sein und / oder umfassen. Der Anteil an Bindermaterial kann zwischen 6 und 15, insbesondere 8 bis 12, Gewichts-% (β-Phase) betragen. Chrom und / oder Vanadium, insbesondere in Form von VC oder Cr₃Cr₂, können ebenfalls, beispielsweise mit einem Anteil zwischen 0,3 und 1,2 Gewichts-%, enthalten sein. Sie können dazu dienen, ein Korngrößenwachstum hemmen. Das Hartmetallstück kann auch TiC, TaC und / oder NbC, beispielsweise mit bis zu 3 Gewichts-%, enthalten.

Allgemein kann das Hartmetallstück aus einem Material mit sehr hoher Härte ausgebildet sein. Es kann insbesondere eine Härte von mindestens 1300 HV10 und beispielsweise bis zu 1450 HV10 und / oder eine Bruchfestigkeit von mindestens 9 MPa.m^{0.5} und beispielsweise bis zu 18 MPa.m^{0.5} aufweisen. Hartmetallstücke mit einer solchen Härte und / oder Bruchfestigkeit können zu akzeptablen Kosten eine weitere Verlängerung der Lebensdauer des Sägeblatts ermöglichen.

Das Hartmetallstück kann ein Sinterkörper sein. Insbesondere kann der Sinterkörper aus Sinterpartikeln von höchstens 2 µm, insbesondere von höchstens 1µm Durchmesser ausgebildet sein. Mit anderen Worten kann die Korngröße der Sinterpartikel höchstens 2 µm, bevorzugt höchstens 1 µm, betragen. Die Größe der Wolframkarbid- und / oder Wolframborid-Sinterpartikel kann höchstens 1,6 µm, insbesondere höchstens 0,8 µm, und vorzugsweise mindestens 0,5 µm, betragen. Dabei hat sich gezeigt, dass die Wahl der Korngrößen, insbesondere ergänzend in Kombination mit den o. g. Anteilen an Bindermaterial, einen besonderen Einfluss auf Härte und / oder Bruchfestigkeit des Hartmetallstücks haben können.

Des Weiteren lässt sich die Lebensdauer des Sägeblatts weiter verlängern, wenn das Hartmetallstück an den übrigen Sägezahn und / oder der Sägezahn an den Grundkörper angeschweißt ist. Vorzugsweise kann das Hartmetallstück widerstandsgeschweißt sein. Alternativ oder ergänzend kann auch ein Strahlschweißverfahren, beispielsweise ein Laser- oder Elektronenstrahl-basiertes Schweißverfahren, verwendet werden.

Auch kann die Lebensdauer weiter verlängert werden, indem wenigstens ein Teil des Sägezahns feststoffgestrahlt, insbesondere sandgestrahlt und / oder kugelgestrahlt, ist. Das Feststoff-Strahlen kann nassstrahlend, insbesondere mit Wasser, erfolgen.

Insbesondere kann durch Feststoffstrahlen eine Oberfläche des noch unbeschichteten Sägezahns, insbesondere des Substrats, vorzugsweise zumindest in einem zu beschichtenden Bereich des Sägezahns, zusätzlich gereinigt werden. Beispielsweise können Oxide und / oder Unreinheiten der Oberfläche des Sägezahns, insbesondere des Substrats, entfernt werden.

Denkbar ist alternativ oder ergänzend auch, zumindest das Substrat, insbesondere vor dem Aufbringen der Beschichtung, in einem Ultraschall-Bad zu reinigen. Dazu kann ein organisches Lösungsmittel, beispielsweise eine Alkohol-basierte Flüssigkeit wie Methanol, Ethanol, Propanol oder dergleichen, verwendet werden.

Auch ist denkbar, dass zumindest ein Teil des beschichteten Sägeblatts feststoffgestrahlt ist. Auch dies kann zu einer Verlängerung der Lebensdauer des Sägeblatts beitragen, insbesondere ist denkbar, dass durch das Feststoffstrahlen im Substrat oder in der Schicht zusätzliche Druckeigenspannung aufgebaut wird. Dies kann die Standzeit des Sägeblatts verlängern.

In den Rahmen der Erfindung fällt des Weiteren ein **Herstellungsverfahren für ein Sägeblatt,** insbesondere für ein Sägeblatt wie es vorangehend und / oder nachfolgend beschrieben ist.

Es werden wenigstens zwei Sägeblätter gemeinsam in einer Kassette zum Aufbringen der Beschichtung aufgenommen. Durch die Aufnahme mehrerer Sägeblätter in die Kassette können mehrere Sägeblätter auf einfache Weise zeitgleich beschichtet werden. Somit lassen sich gegenüber einer sequenziellen Beschichtung der Sägeblatter Zeit und damit erhebliche Kosten einsparen, ohne dass merkliche Qualitätseinbuße zu befürchten wären.

In eigenen Testreihen hat es sich dabei als besonders günstig erwiesen, die Beschichtung durch Lichtbogenverdampfen aufzubringen. Die Temperatur auf den zu beschichtenden Sägeblättern und / oder in der Kammer, in der die Beschichtung erfolgt, kann während der Beschichtung mittels Lichtbogenverdampfens unter oder bis zu 500 °C betragen.

Mindestens kann ein Teil des Sägezahns, insbesondere das Hartmetallstück umfassend, beschichtet werden. Vorzugsweise wird der Sägezahn vollständig beschichtet.

Denkbar ist auch, dass zumindest ein Teil des Grundkörpers beschichtet wird. Beispielsweise kann wenigstens 10 % des Grundkörpers beschichtet werden. Der Umfang der Beschichtung kann beispielsweise höchstens 75 % des Grundkörpers betragen, sodass trotz Beschichtens des Grundkörpers dennoch mehrere Sägeblätter vergleichsweise dicht nebeneinander und / oder übereinander in der Kassette aufnehmbar sind. Somit kann eine vergleichsweise hohe Anzahl von Sägeblättern gleichzeitig beschichtet werden und dennoch kann eine ausreichende, insbesondere gleichmäßige, Beschichtung jedes einzelnen Sägeblatts sichergestellt werden.

Das Sägeblatt kann in wenigstens einer Phase des Verfahrens feststoffgestrahlt, insbesondere sandgestrahlt, werden. Insbesondere kann das Substrat des Sägeblatts feststoffgestrahlt, insbesondere sandgestrahlt, werden. Denkbar ist auch, die Oberfläche der Beschichtung des Sägeblatts feststoffzustrahlen, insbesondere sandzustrahlen. Es kann vorzugsweise mit einem Druck von bis zu 1 MPa feststoffgestrahlt werden.

Weiter fällt in den Rahmen der Erfindung eine **Kassette** zur Herstellung eines Sägeblattes wie es vorangehend und / oder nachfolgend beschrieben ist. Die Herstellung des Sägeblatts kann dabei entsprechend dem vorangehend und / oder nachfolgend beschriebenen Herstellungsverfahren erfolgen. Die Kassette weist wenigstens zwei Aufnahmestellen zur Aufnahme von wenigstens zwei Sägeblättern auf. Jedes der zwei Sägeblätter weist jeweils wenigstens einen Grundkörper und jeweils wenigstens einen Sägezahn auf. Die Aufnahmestellen sind zur Aufnahme der Sägeblätter an ihren Grundkörpern ausgebildet. Insbesondere sind sie so ausgebildet, dass die Sägezähne nach Aufnahme der Sägeblätter in den Aufnahmestellen jeweils von der Kassette wegweisen.

Weitere Merkmale und Vorteile der Erfindung ergeben sich aus der nachfolgenden detaillierten Beschreibung von Ausführungsbeispielen der Erfindung, anhand der Figuren der Zeichnung, die erfindungswesentliche Einzelheiten zeigt, sowie aus den Ansprüchen. Die dort gezeigten Merkmale sind nicht notwendig maßstäblich zu verstehen und derart dargestellt, dass die erfindungsgemäßen Besonderheiten deutlich sichtbar gemacht werden können. Die verschiedenen Merkmale können je einzeln für sich oder zu mehreren in beliebigen Kombinationen bei Varianten der Erfindung verwirklicht sein.

In der schematischen Zeichnung sind Ausführungsbeispiele der Erfindung dargestellt und in der nachfolgenden Beschreibung näher erläutert.

### Es zeigen:

- Fig. 1: eine Seitenansicht eines Sägeblattes für eine Säbelsäge;
- Fig. 2: eine Seitenansicht eines Sägeblattes für eine Stichsäge;
- Fig. 3: eine Seitenansicht eines Ausschnitts des Sägeblatts gemäß Fig. 2;
- Fig. 4: eine Seitenansicht eines Ausschnitts des Sägeblattes gemäß Fig. 2;
- Fig. 5: eine schematische Darstellung einer Beschichtung;
- Fig. 6: eine Messapparatur;
- Fig. 7: ein Diagramm zu Schneidleistungen verschiedener Sägeblätter;
- Fig. 8: ein Diagramm zu Lebensdauern verschiedener Sägeblätter;
- Fig. 9: eine schematische Darstellung einer Beschichtungskammer und
- Fig. 10a bis 10g: verschiedene Ansichten einer mit einer Vielzahl von Sägeblättern befüllten Kassette.

In der nachfolgenden Beschreibung der Figuren werden zur Erleichterung des Verständnisses der Erfindung für gleiche oder sich funktional entsprechende Elemente jeweils die gleichen Bezugszeichen verwendet.

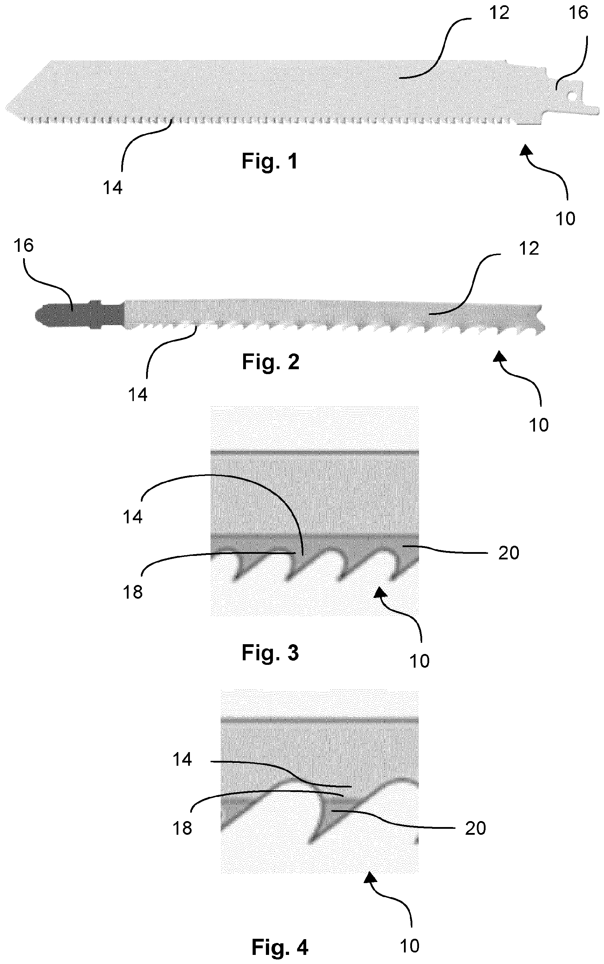

**Fig. 1** zeigt ein erstes Sägeblatt **10** für eine Säbelsäge. **Fig. 2** zeigt ein Sägeblatt 10 für eine Stichsäge. Die Sägeblätter 10 bilden somit linear schneidende Sägeblätter.

Die Sägeblätter 10 weisen jeweils einen Grundkörper **12** auf. Die Grundkörper 12 sind aus einem Stahl gefertigt.

An den Grundkörpern 12 sind jeweils eine Vielzahl von Sägezähnen **14** ausgebildet. Von diesen ist aus Gründen der Übersichtlichkeit in Fig. 1 und Fig. 2 - sowie auch in nachfolgend beschriebenen Fig. 3 und Fig. 4 - jeweils nur ein Sägezahn 14 mit einem Bezugszeichen markiert. Die Sägeblätter 10 können als Universalsägeblätter, insbesondere zum Sägen von Metallen, Metalllegierungen, Holz und / oder Kunststoff, ausgebildet sein. Dazu können die Sägezähne 14 eine entsprechend abgestimmte Form aufweisen. Die Form kann insbesondere vom zu bearbeitenden Werkstück, insbesondere dessen Material, abhängen.

Die Sägeblätter 10 weisen eine Länge von ca. 13 cm (Fig. 2) und von ca. 35 cm (Fig. 1) auf. Ihre Dicken betragen zwischen 1 mm und 2 mm, insbesondere zwischen 0,75 mm und 2,0 mm. Ihre Breiten betragen zwischen 2 cm und 3 cm, insbesondere zwischen 15 mm und 30 mm.

Einenends weisen die Sägeblätter 10 Verbindungsabschnitte **16** auf, sodass die Sägeblätter 10 in einer entsprechenden Werkzeugmaschine, beispielsweise einer Handwerkzeugmaschine, aufnehmbar sind.

**Fig. 3 und Fig. 4** zeigen jeweils in vergrößerter Darstellung Ausschnitte von alternativen Ausführungsformen des Sägeblattes 10 gemäß Fig. 2.

Den Sägeblättern 10 gemäß aller dargestellten Ausführungsformen ist gemeinsam, dass die Sägezähne 14 ein Substrat **18** aufweisen. Auf das Substrat 18 ist zumindest teilweise eine Beschichtung **20** aufgebracht. Aus Gründen der Übersichtlichkeit ist in Fig. 3 und Fig. 4 jeweils nur ein Substrat 18 mit einem Bezugszeichen markiert.

In der Ausführungsform gemäß Fig. 3 erstreckt sich die Beschichtung 20 über die gesamten Substrate 18 bis auf den Grundkörper 12. In der Ausführungsform gemäß Fig. 4 erstreckt sich die Beschichtung 20 lediglich auf Teilbereiche der Substrate 18 und damit der Sägezähne 14.

Das Substrat 18 ist aus Hartmetall ausgebildet. Die Sägezähne 14, insbesondere die Substrate 18, sind mittels Widerstandsschweißen, Elektronenstrahlschweißen und / oder Laserstrahlschweißen an den zugehörigen Grundkörper 12 angeschweißt. Dabei können entweder jeweils die Sägezähne 14 einzeln angeschweißt sein. Alternativ können die Sägezähne 14 an einer Leiste ausgebildet sein und die Liste insgesamt mit dem Grundkörper 12 verschweißt sein.

Die Sägezähne 14 sind mit einer Dichte entsprechend zwischen 4 und 10 Sägezähnen pro Zoll bzw. pro 2,54 cm, angeordnet. Die Sägezähne 14 sind somit in regelmäßigen Abständen von 2,5 mm bis 6,4 mm voneinander angeordnet.

Bei alternativen Sägeblättern 10 kann das Substrat 18 aus einem Bimetall ausgebildet sein. Die Dichte der Sägezähne 14 kann zwischen 8 und 25 Sägezähnen pro Zoll bzw. pro 2,54 cm entsprechen. Die Sägezähne 14 sind somit in regelmäßigen Abständen von 1,0 mm bis 3,2 mm voneinander angeordnet.

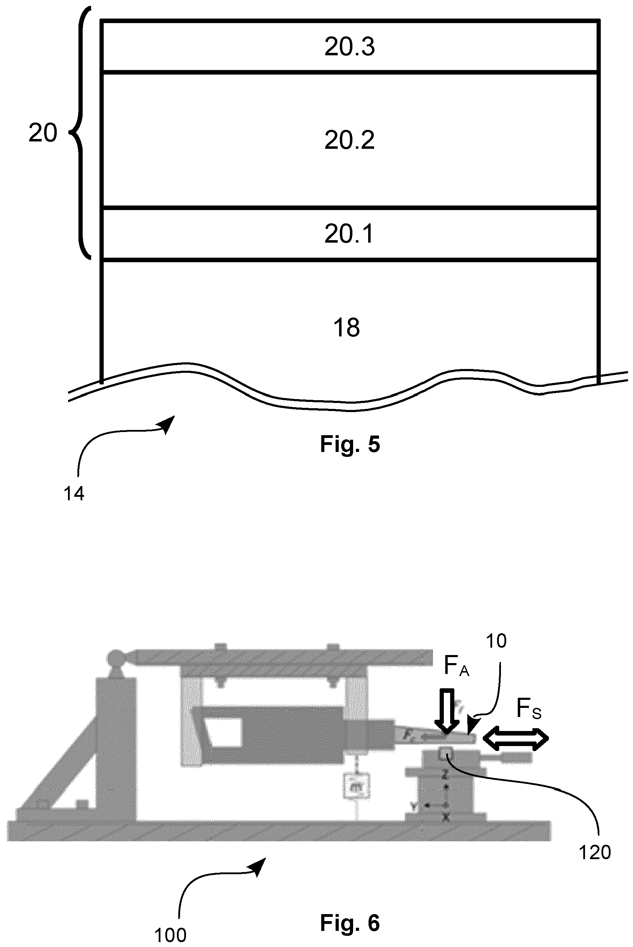

Anhand von **Fig. 5****,** die die Beschichtung 20 schematisch darstellt, wird die Struktur der Beschichtung 20 näher erläutert. Dazu zeigt Fig. 5 schematisch einen Ausschnitt eines Querschnitts durch einen Sägezahn 14.

Das Substrat 18 ist als Hartmetallstücke ausgebildet. Insbesondere ist es durch Sintern hergestellt und bildet somit einen Sinterkörper, wobei der zugehörige Grünling aus Sinterpartikeln mit Durchmessern von ca. 1 µm hergestellt worden ist.

An das Substrat 18 grenzt eine Haftvermittlungsschicht **20.1** an. Auf diese ist eine keramische Schutzschicht mit zwei Teilschichten **20.2** und **20.3** aufgebracht. Dabei bildet die Teilschicht 20.3 eine Oberfläche der Beschichtung 20 und damit des Sägezahns 14.

Die Außenseite des Substrats 18, d. h. die Oberfläche des Substrats 18, auf die die Haftvermittlungsschicht 20.1 aufgebracht ist, ist vor Aufbringen der Haftvermittlungsschicht 20.1 sandgestrahlt und in einem Bad mit einem organischen Lösungsmittel, insbesondere ein Ethanol-haltiges Lösungsmittel, Ultraschall-gereinigt, um eine möglichst gute Haftung der Haftvermittlungsschicht zu erreichen.

Die Haftvermittlungsschicht 20.1 ist Titan-haltig. Sie weist einen Konzentrationsgradienten auf in Bezug auf den Gehalt von Titan wobei die Konzentration von der Seite des Substrats 18 bis zu der Seite, an die die Teilschicht 20.2 angrenzt, ansteigt.

Die Schutzschicht, insbesondere die Teilschicht 20.2, weist, insbesondere als Hauptbestandteil, AITiSiCN auf.

Die Teilschicht 20.3 kann als Mono-Layer ausgebildet sein. Sie ist als Anti-Oxidationsschicht ausgebildet.

Die Dicke der Beschichtung 20 beträgt insgesamt zwischen 1 µm und 4 µm.

Die Beschichtung 20 ist nassgestrahlt. So können Oberflächendefekte wie z. B. Droplets eliminiert werden.

Insgesamt ist die Beschichtung 20 verschleißfester als das Substrat 18. Sie weist eine Härte von 3 * 10³ HV auf. Das Substrat 18 weist dagegen eine Härte von ca. 1,4 * 10³ HV auf.

Mit derartigen Sägeblättern 10 wurden Verschleißtests mittels einer in **Fig. 6** abgebildeten Messapparatur **100** durchgeführt.

Die Messapparatur 100 ist eingerichtet, mit einer definierten Anpresskraft **F**_{A} und einer definierten Schneidkraft **F**ₛ ein Probewerkstück 102, insbesondere ein L-Profil-Stahl, mit einem zu prüfenden Sägeblatt 10 durchzusägen. Erfasst werden die Zeitdauer für einen vollständigen Schnitt des Probewerkstücks 102, die Lebensdauer, in Form der maximal möglichen Anzahl vollständiger Schnitte bis zum Erreichen eines definierten Verschleißgrades sowie in Form der Gesamtdauer.

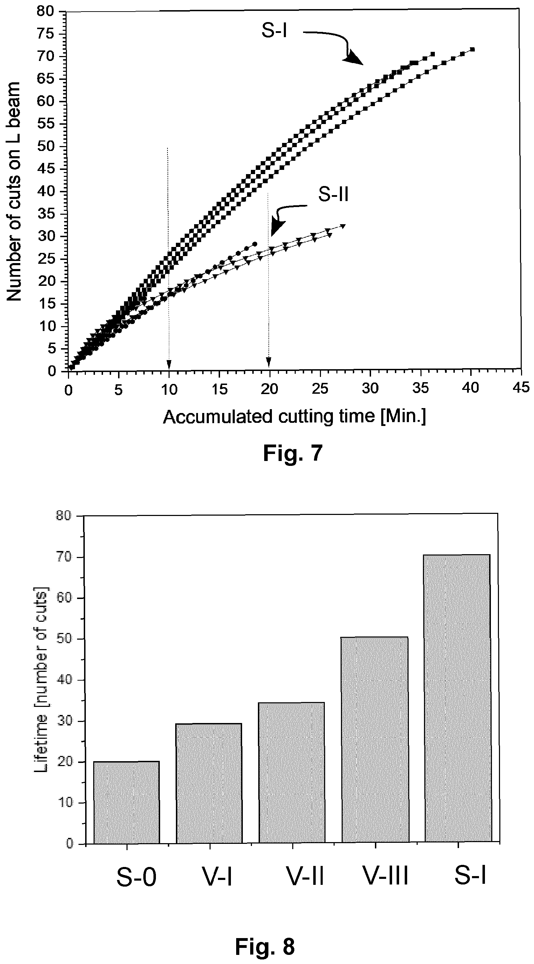

**Fig. 7** zeigt ein Diagramm zu Schneidleistungen verschiedener Sägeblätter. Die mit **S-I** markierten Kurven korrespondieren zu Sägeblättern 10. Mit **S-II** markierte Kurven korrespondieren zu zum Testzeitpunkt am Markt verfügbaren Hochleistungssägeblättern, darunter auch ein bisher von der Anmelderin als leistungsstärkstes bzw. verschleißärmstes lineares Sägeblatt eingestuftes Sägeblatt.

Zu erkennen ist, dass die Sägeblätter 10 eine erheblich längere Lebensdauer aufweisen. So konnten bis über 70 Schnitte gegenüber höchstens knapp über 30 Schnitten, also mehr als doppelt so viele Schnitte im Vergleich zu den derzeitigen Hochleistungssägeblättern, ausgeführt werden.

Die Sägeblätter 10 erreichten zudem bis über 40 Minuten Einsatzdauer im Kontrast zu weniger als 30 Minuten maximaler Einsatzdauern der bisherigen Hochleistungssägeblätter.

Anhand der Steigungen, insbesondere zu Beginn der Sägeversuche, zeigte sich auch eine erheblich verbesserte Schnittgeschwindigkeit:
Während mit Sägeblättern 10 binnen der ersten 10 Minuten 24 bis 27 Schnitte ausgeführt werden konnten, erreichten die Vergleichssägeblätter lediglich bis zu 17 bis 18 Schnitte. Ähnliche Leistungsvorteile ergaben sich auch über die ersten 20 Minuten hinweg.

Insgesamt übertrafen somit die Leistungen der Sägeblätter 10 die Leistungen der Vergleichssägeblätter um ca. 33 bis weit über 100 Prozent.

**Fig. 8** zeigt in einem Diagramm Lebensdauern verschiedener Varianten der Sägeblätter 10. Insbesondere unterscheiden sich diese hierzu untersuchten Varianten von den vorangehend beschriebenen Sägeblättern 10 durch das Material der Teilschicht 20.2.

Sägeblattvariante **S-0** entspricht einem unbeschichteten Sägeblatt, d. h. mit dem Substrat 18 entsprechenden Schneidleistungen.

Sägeblattvariante **V-I** entspricht einem Sägeblatt 10, wobei die Teilschicht 20.2 anstelle von AITiSiCN eine Mischung aus TiAIN und TiCN aufweist.

Sägeblattvariante **V-II** entspricht einem Sägeblatt 10, wobei die Teilschicht 20.2 anstelle von AITiSiCN mehrere Lagen aus TiAIN aufweist.

Sägeblattvariante **V-III** entspricht einem Sägeblatt 10, wobei die Teilschicht 20.2 anstelle von AITiSiCN AICrN aufweist.

S-I entspricht entsprechend zu Fig. 7 den Sägeblättern 10 wie vorangehend beschrieben.

Zu erkennen ist, dass alle Sägeblattvarianten V-I, V-II, V-III sowie S-I eine Leistungssteigerung bzw. einen verminderten Verschleiß gegenüber einem allein auf dem Substrat 18 basierenden Sägeblatt bieten. Besonders vorteilhaft zeigt sich dabei das Sägeblatt 10 mit der AITiSiCNhaltigen Teilschicht 20.2.

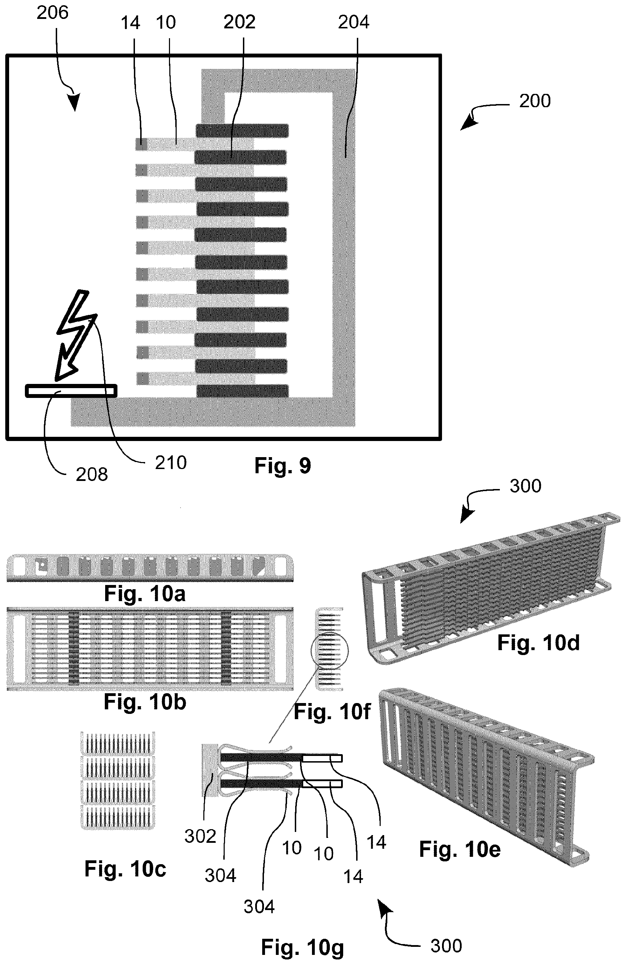

Im Folgenden wird ein Herstellverfahren für ein Sägeblatt 10 anhand von Fig. 9 und Fig. 10a bis 10g näher erläutert.

Zur Herstellung von Sägeblättern 10 werden Grundkörper 12 einschließlich der Verbindungsabschnitte 16 zugeschnitten, beispielsweise ausgestanzt.

Anschließend werden Sägezähne 14 aus Sinterpulver zu Grünlingen geformt und diese zu Sinterkörpern gesintert. Das Sinterpulver kann dabei Sinterpartikel, insbesondere Wolframcarbid-Sinterpartikel, mit beispielsweise einem mittleren Durchmesser von ca. 1 µm umfassen.

Die Sägezähne 14, insbesondere in Form der Sinterkörper, werden anschließend, beispielsweise per Laserschweißen und / oder per Widerstandsschweißen an den jeweligen Grundkörper 12 angeschweißt.

Anschließend werden zumindest die Sägezähne sandgestrahlt und Ultraschall-gereinigt.

Nun wird die Beschichtung 20 auf die Sägezähne 14 und, je nach gewünschter Ausführungsart, beispielsweise entsprechend Fig. 3 oder Fig. 4, gegebenenfalls auch auf die Grundkörper 12 aufgebracht.

Vorliegend wird vorgeschlagen, dass die Beschichtung 20 mittels Lichtbogenverdampfen in einer Beschichtungskammer **200,** siehe **Fig. 9****,** aufgebracht wird. Dazu zeigt Fig. 9 in schematischer Darstellung eine Schnittansicht durch die Beschichtungskammer 200.

In der Beschichtungskammer 200 sind eine Vielzahl von zunächst unbeschichteten Sägeblättern 10 übereinandergestapelt. Mit Abstandselementen **202,** die jeweils zwischen zweien der Sägeblätter 10 angeordnet sind, wird ein definierter Abstand zwischen den Sägeblättern 10 sichergestellt. Somit entsprechen sich die Größen, insbesondere Höhen, der Zwischenräume zwischen den Sägeblättern 10. Dies kann zu einer konstanten Qualität der aufzubringenden Beschichtung über Sägeblätter 10 hinweg beitragen.

Aus Gründen der Übersichtlichkeit sind in Fig. 9 wiederum Bezugszeichen zu lediglich einem Sägeblatt 10, dem zugehörigen Sägezahn 14 und einem benachbarten Abstandselement 202 eingetragen.

Eine Klemmvorrichtung **204** hält den Stapel aus Sägeblättern 10 auf Position.

Die Sägeblätter 10 sind dabei derart angeordnet, dass ihre Sägezähne 14 gemeinsam in einen Innenraum **206** weisen.

Im Innenraum 206 befindet sich Beschichtungsmaterial **208.** Die Art, insbesondere die stoffliche Zusammensetzung, des Beschichtungsmaterials 208 kann von der zu beschichtenden Teilschicht der Beschichtung 20 abhängen. Das Beschichtungsmaterial 208 wird mittels eines in Fig. 9 schematisch dargestellten Lichtbogens **210** verdampft, sodass es sich dann an den Sägeblättern 10, insbesondere im Bereich der Sägezähne 14, abscheidet.

Um eine Vielzahl von Sägeblättern 10 gleichzeitig und mit präzise definierten Abständen zueinander in die Beschichtungskammer einbringen und dort halten zu können, kann eine Kassette **300,** wie in **Fig. 10a bis Fig. 10g** in unterschiedlichen Perspektiven gezeigt, verwendet werden.

Somit können wenigstens zwei Sägeblätter 10 gemeinsam in der Kassette 300 zum Aufbringen der Beschichtung 20 aufgenommen werden.

Wie beispielsweise anhand von **Fig. 10g** erkennbar, umfasst die Kassette 300 einen Rahmen **302,** an dem jeweils Klemmspangen-Paare **304** angeordnet sind. Die Klemmspangen-Paare 304 weisen jeweils zwei Klemmspangen auf.

In jeweils ein Klemmspangen-Paar 304 kann jeweils ein Sägeblatt 10 eingelegt und insbesondere eingeklemmt werden. Sie bilden somit jeweils Aufnahmestellen für die Sägeblätter 10.

Beim Einlegen werden die Sägeblätter 10 dabei derart orientiert, dass ihre Sägezähne 14 vom Rahmen 302 wegweisen. Somit können die Sägezähne 10 später in den Innenraum 206 der Beschichtungskammer 200 (beide Fig. 9) hineinragen.

Die Klemmspangen-Paare 304 sind jeweils in regelmäßigen, gleichen Abständen voneinander angeordnet, sodass sie auch als Abstandshalter entsprechend der Abstandshalter 202 (Fig. 9) fungieren können. Die Klemmspangen der Klemmspangen-Paare 304 weisen eine Länge auf, die geringer als die Breite der Grundkörper 12 ist. Somit kann sichergestellt werden, dass die Klemmspangen nicht die Sägezähne 14 erreichen oder überragen, sodass alle Sägezähne gleichmäßig beschichtet werden können.

Der Bereich, der mit der Beschichtung 20 beschichtet wird, insbesondere ob somit die Beschichtung entsprechend beispielsweise gemäß Fig. 3 oder Fig. 4 aufgebracht wird, kann unter anderem durch Wahl der Abstände zwischen den Sägeblättern 10, beispielsweise durch Wahl entsprechender Kassetten 300, sowie durch Wahl von Prozessparametern wie beispielsweise der Aufenthaltsdauer der Kassetten 300 mit den Sägeblättern 10 in der Beschichtungskammer 200 eingestellt werden.

Nach der Abschluss des Beschichtungsprozesses können die Sägeblätter 10 bzw. die Kassetten 300 mit den Sägeblättern 10 aus der Beschichtungskammer 200 entnommen werden.

In einer abschließenden Phase können die Sägeblätter 10, insbesondere deren Sägezähne 14, sandgestrahlt werden. Der Strahldruck kann dazu auf weniger als 1 MPa eingestellt sein.

### Bezugszeichenliste

- 10: Sägeblatt
- 12: Grundkörper
- 14: Sägezahn
- 16: Verbindungsabschnitt
- 18: Substrat
- 20: Beschichtung
- 20.1: Haftvermittlungsschicht
- 20.2: Teilschicht
- 20.3: Teilschicht
- 100: Messapparatur
- 200: Beschichtungskammer
- 202: Abstandselement
- 204: Klemmvorrichtung
- 206: Innenraum
- 208: Beschichtungsmaterial
- 210: Lichtbogen
- 300: Kassette
- 302: Rahmen
- 304: Klemmspangen-Paar
- FA: Anpresskraft
- FS: Schneidkraft
- S-0: Sägeblattvariante
- S-I: Sägeblatt
- S-II: bekanntes Hochleistungssägeblatt
- V-I: Sägeblattvariante
- V-II: Sägeblattvariante
- V-III: Sägeblattvariante

## Patentansprüche

1. **Sägeblatt** (10), insbesondere linear schneidendes Sägeblatt (10) für eine Säbelsäge oder eine Stichsäge, umfassend einen Grundkörper (12), an dem wenigstens ein Sägezahn (14) angeordnet und / oder ausgebildet ist,
- wobei der Sägezahn (14) ein Substrat (18) aufweist, das wenigstens teilweise mit einer Beschichtung (20) beschichtet ist,
- wobei die Beschichtung (20) eine Haftvermittlungsschicht (20.1) und wenigstens eine keramische Schutzschicht (20.2, 20.3) aufweist, wobei die Schutzschicht (20.2, 20.3) verschleißfester als das Substrat (18) ist.

2. Sägeblatt nach dem vorhergehenden Anspruch, **dadurch gekennzeichnet, dass** die Beschichtung (20) eine Dicke von mindestens 1 µm, insbesondere wenigstens 2 µm, und vorzugsweise von höchstens 6 µm, insbesondere von höchstens 4µm, aufweist.

3. Sägeblatt nach einem der vorhergehenden Ansprüche, **dadurch gekennzeichnet, dass** die Beschichtung eine Härte von 2500 - 3000 gemessen nach ISO 21874:2019 aufweist.

4. Sägeblatt nach einem der vorhergehenden Ansprüche, **dadurch gekennzeichnet, dass** die Haftvermittlungsschicht (20.1) Titan aufweist.

5. Sägeblatt nach einem der vorhergehenden Ansprüche, **dadurch gekennzeichnet, dass** die Haftvermittlungsschicht (20.1) einen Konzentrationsgradienten aufweist.

6. Sägeblatt nach einem der vorhergehenden Ansprüche, **dadurch gekennzeichnet, dass** die Schutzschicht (20.2, 20.3) wenigstens eines aus AITiCN, TiAINi, TiAIN, AITiSiCN oder TiCN aufweist.

7. Sägeblatt nach einem der vorhergehenden Ansprüche, **dadurch gekennzeichnet, dass** die Schutzschicht (20.2, 20.3) wenigstens eines aus Silizium, Zirkonium oder AICrN aufweist.

8. Sägeblatt nach einem der vorhergehenden Ansprüche, **dadurch gekennzeichnet, dass** der Sägezahn (14) ein Hartmetallstück aufweist.

9. Sägeblatt nach einem der vorhergehenden Ansprüche, **dadurch gekennzeichnet, dass** das Hartmetallstück eine Härte im Bereich von 1300 HV10 bis 1450 HV10 und / oder eine Bruchfestigkeit im Bereich von 9 MPa.m^{0.5} bis 18 MPa.m^{0.5} aufweist.

10. Sägeblatt nach einem der vorhergehenden Ansprüche, **dadurch gekennzeichnet, dass** das Hartmetallstück ein Sinterkörper aus Sinterpartikeln von höchstens 2 µm, insbesondere von höchstens 1µm Durchmesser ist.

11. Sägeblatt nach einem der vorhergehenden Ansprüche, **dadurch gekennzeichnet, dass** wenigstens ein Teil des Sägezahns (14) feststoffgestrahlt, insbesondere sandgestrahlt, ist.

12. **Herstellungsverfahren** für ein Sägeblatt (10) nach einem der vorhergehenden Ansprüche, **dadurch gekennzeichnet, dass** wenigstens zwei Sägeblätter (10) gemeinsam in einer Kassette zum Aufbringen der Beschichtung aufgenommen werden.

13. Herstellungsverfahren nach dem vorhergehenden Anspruch, **dadurch gekennzeichnet, dass** die Beschichtung (20) durch Lichtbogenverdampfen aufgebracht wird.

14. Herstellungsverfahren nach einem der Ansprüche 12 bis 13, **dadurch gekennzeichnet, dass** das Sägeblatt (10) feststoffgestrahlt, insbesondere sandgestrahlt, wird.

15. **Kassette** (300) zur Herstellung eines Sägeblattes (10) nach einem der Ansprüche 1 bis 11 gemäß dem Herstellungsverfahren nach einem der Ansprüche 12 bis 14, **dadurch gekennzeichnet, dass** die Kassette (300) wenigstens zwei Aufnahmestellen, insbesondere Klemmspangen-Paare (304), aufweist zur Aufnahme von wenigstens zwei Sägeblättern (10), die jeweils wenigstens einen Grundkörper (12) und jeweils wenigstens einen Sägezahn (14) aufweisen, wobei die Aufnahmestellen zur Aufnahme der Sägeblätter (10) an ihren Grundkörpern (12) ausgebildet sind, so dass die Sägezähne (10) nach Aufnahme der Sägeblätter (10) in den Aufnahmestellen jeweils von der Kassette (300) wegweisen.
